Europäisches Patentamt

European Patent Office

Office européen des brevets

(11) Numéro de publication: **0017701**
**A1**

# (12) DEMANDE DE BREVET EUROPEEN

(21) Numéro de dépôt: 80100326.0

(22) Date de dépôt: 23.01.80

(51) Int. Cl.³: **H 01 L 31/02**, G 02 B 7/26

(30) Priorité: 16.04.79 US 30401

(43) Date de publication de la demande: 29.10.80
Bulletin 80/22

(84) Etats contractants désignés: **DE FR GB**

(71) Demandeur: **International Business Machines Corporation, Armonk, N.Y. 10504 (US)**

(72) Inventeur: **Noel, Jr. Francis Edward, 101 Boland Way, Knightdale, NC 27545 (US)**

(74) Mandataire: **Bonin, Jean-Jacques, COMPAGNIE IBM FRANCE Département de Propriété Industrielle, F-06610 La Gaude (FR)**

(54) **Dispositif de couplage pour transducteur optique monté sur un substrat.**

(57) Ce dispositif permet de réaliser un couplage optique entre un transducteur (10) monté sur un substrat (12) et une fibre optique (20). Le substrat comporte une ouverture (21) à l'intérieur de laquelle est insérée une broche métallique creuse (18). La fibre optique (20) est montée à l'intérieur de la broche (18) de façon que son extrémité soit disposée en regard de la partie active (24) du transducteur (10). Un revêtement conducteur (25) sur le substrat (12) permet de réaliser une connexion électrique entre la broche (18) et le transducteur (10).

## DISPOSITIF DE COUPLAGE POUR TRANSDUCTEUR OPTIQUE MONTE SUR UN SUBSTRAT

### Description

### Domaine technique

La présente invention concerne les transducteurs optiques et, plus particulièrement, un dispositif permettant d'obtenir un meilleur couplage des signaux lorsqu'un transducteur optique est monté sur un substrat isolant.

### Etat de la technique antérieure

Les sources optiques à l'état solide, telles que les diodes électro-luminescentes et les lasers à injection, et les détecteurs optiques, tels que les photo-diodes PIN, sont généralement employés dans des circuits à l'état solide enrobés dans un matériau protecteur. La réalisation du chemin que doivent suivre les signaux optiques destinés à de tels transducteurs ou provenant de ces derniers est à la fois coûteuse et compliquée. Les techniques connues qui sont employées pour assurer le couplage optique nécessaire consistent notamment à faire passer la fibre optique dans un orifice percé dans la paroi du capot métallique qui recouvre le transducteur et le substrat sur lequel ce dernier est monté. Il est difficile en pareil cas d'obtenir un joint étanche au point de pénétration de la fibre optique et, d'autre part, la connexion obtenue est relativement fragile.

Une autre technique connue que l'on emploie pour assurer un couplage optique entre un transducteur contenu dans un boîtier étanche et un circuit optique externe consiste à pratiquer une fenêtre transparente dans le

2

boîtier. Cette technique présente l'inconvénient d'augmenter le coût du boîtier et, par ailleurs, la séparation physique nécessaire entre le transducteur et l'extrémité de la fibre optique peut entraîner une diminution considérable de l'amplitude des signaux au niveau de l'interface.

L'un des objets de la présente invention est donc de fournir un dispositif de couplage utilisable avec un transducteur optique monté sur un substrat isolant. Ce dernier comporte un trou préformé qui est aligné avec la région active du transducteur. L'élément de couplage comprend une broche métallique creuse qui pénètre dans ce trou et qui contient un noyau conducteur de lumière dont une extrémité se trouve à proximité immédiate de ladite région active.

D'autres objets, caractéristiques et avantages de la présente invention ressortiront mieux de l'exposé qui suit, fait en référence aux dessins annexés à ce texte, qui représentent un mode de réalisation préféré de celle-ci.

Brève description des figures

La Figure 1 est une vue en perspective d'une réalisation d'un transducteur et du substrat sur lequel il est monté.

La Figure 2 est une coupe de transducteur et du substrat qui lui est associé, ce dernier incorporant la présente invention.

La Figure 3 est une vue en perspective d'un transducteur et des circuits associés contenus dans un module étanche.

3

La Figure 4 est une coupe d'une version d'un connecteur électrique/optique externe utilisable avec l'élément de couplage de l'invention.

La Figure 5 est une vue en perspective représentant une partie d'un dispositif de couplage de signaux réalisé conformément à la présente invention et qui est utilisé avec un type différent de transducteur optique.

Description de l'invention

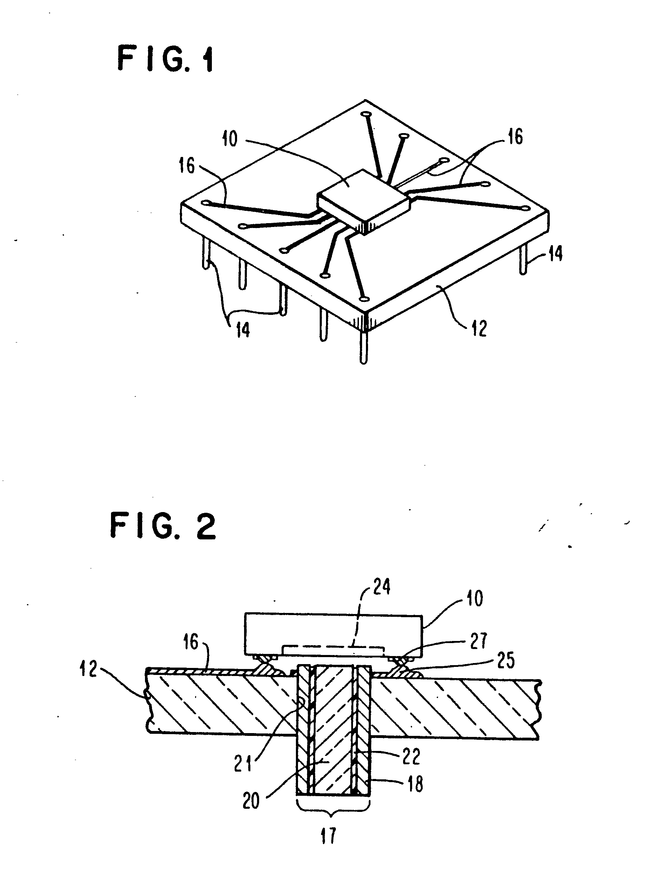

On a représenté sur la Figure 1 un transducteur optique à l'état solide 10 monté sur un substrat isolant 12. Ce dernier est de préférence en céramique. Le transducteur 10 peut être une source lumineuse, telle qu'une diode électro-luminescente ou un laser à injection ou un détecteur de lumière, tel qu'une photo-diode. Les connexions électriques entre le transducteur 10 et des circuits externes sont réalisés par l'intermédiaire d'un ensemble de broches métalliques pleines 14 qui sont fixées au substrat 12 en les insérant dans des évidements préformés que comporte celui-ci. En général, les broches 14 ont un diamètre légèrement supérieur à celui des trous préformés de manière à obtenir un ajustage serré. Des chemins conducteurs 16 s'étendent depuis chacune des broches 14 jusqu'à des bornes situées sur la surface inférieure du transducteur 10.

La région active 24 du transducteur 10 se trouve sur la surface de celui-ci qui se trouve en face du substrat 12. Ce dernier comporte un trou préformé supplémentaire aligné avec le transducteur de manière à créer un chemin de signaux optiques vers la région active. Comme le montre la Figure 2, un élément de couplage de signaux 17 comprend une broche métallique creuse 18 qui est insérée dans un trou préformé 21 en utilisant la même

4

technique d'insertion que dans le cas des broches 14 situées à la périphérie du substrat 12. La broche 18 entoure une fibre optique 20 (ou autre élément analogue susceptible de transmettre la lumière) qui peut être maintenue en place au moyen d'une couche 22 d'un adhésif époxyde. Le transducteur 10 est monté sur le substrat 12 directement au-dessus de l'élément 17, le centre de sa région active 24 coïncidant avec l'axe longitudinal de l'extrémité exposée de la fibre optique 20. L'extrémité de l'élément 17 est séparée du transducteur 10 par une distance de l'ordre de 0,0254 à 0,0762 millimètre afin d'éviter tout contact indésirable entre l'élément 17 et le matériau semi-conducteur relativement mou qui constitue le transducteur 10.

La fibre optique 20 permet de transmettre les signaux optiques vers la région active 24 ou depuis celle-ci, selon la nature du transducteur 10. La broche métallique creuse 18 peut servir à transmettre des signaux électriques ou des tensions au transducteur 10, en ajoutant simplement un chemin conducteur 25 entre l'extrémité opposée de la broche 18 et l'une des bornes 27 du transducteur. La broche métallique 18 fait également fonction de puits de chaleur car elle constitue un chemin thermique permettant d'évacuer la chaleur engendrée par le transducteur 10 vers le substrat 12.

L'emploi d'une broche métallique creuse présentant les mêmes dimensions extérieures que les broches métalliques pleines servant à établir d'autres connexions électriques permet d'établir le chemin de transmission des signaux vers le transducteur 10 au moyen des techniques classiques d'insertion et d'étanchéisation des broches.

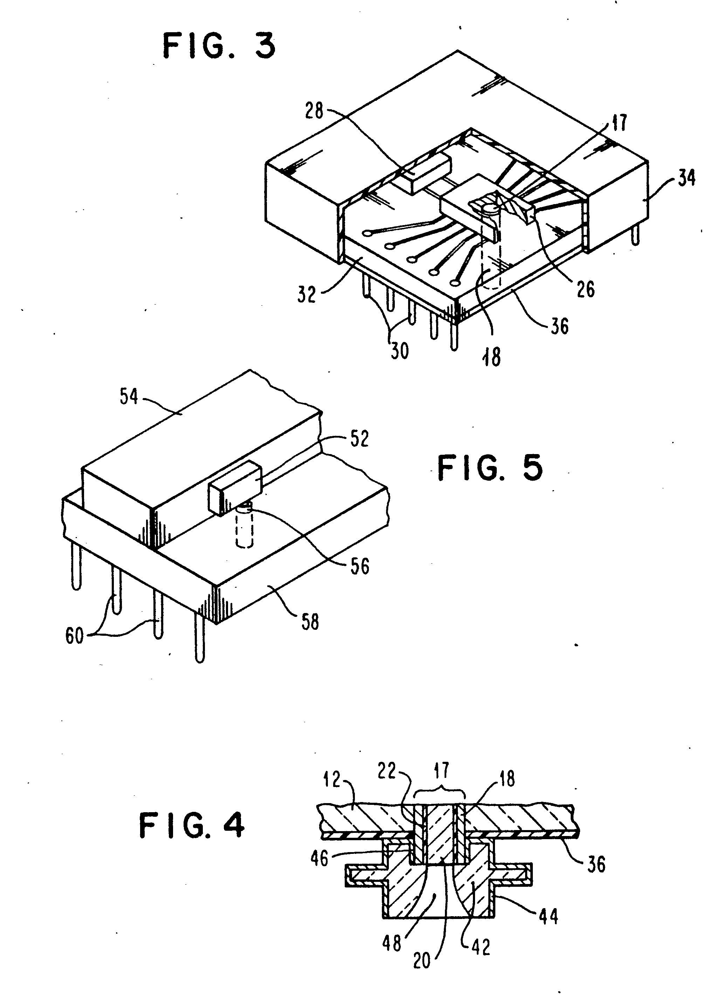

La Figure 3 représente un module étanche comprenant un transducteur 26 et des circuits électriques associés 28 qui se présentent sous la forme de circuits intégrés. La transmission des signaux vers le dispositif 26 est assurée par un élément de couplage 17 du type précédemment décrit. Une fois que cet élément et d'autres broches métalliques pleines 30 ont été insérés dans un substrat 32 servant de support, l'ensemble est maintenu et rendu étanche au moyen d'un capot métallique 34 et d'un couche 36 d'un produit de scellement époxyde. Ce dernier assure également l'étanchéité des broches 30 et 18 insérées dans le substrat.

Des connexions optiques et électriques externes au module décrit ci-dessus peuvent être réalisées en utilisant un composant du type représenté sur la Figure 4. La broche métallique creuse 18 et la fibre optique 20 qu'elle contient sont insérées dans le trou préformé du substrat 12 et de la couche 36, de façon que l'extrémité externe de la broche constitue une légère protubérance. Un raccord 42, qui peut être constitué par du verre recouvert d'une couche de métal 44, est inséré par pression sur la partie protubérante de l'élément 17. Le raccord 42 comporte un évidement central comprenant une première partie cylindrique 46 dont le diamètre correspond approximativement à celui de la broche métallique creuse 18, prolongée par une embouchure évasée 18, dont le plus petit diamètre correspond sensiblement à celui de la fibre optique 20. Cette configuration évasée permet de guider une fibre optique externe (non représentée) de telle sorte qu'elle se trouve dans l'alignement de la fibre optique 20 que comporte l'élément de couplage 17.

La présente invention peut également être utilisée avec des dispositifs à l'état solide à émission latérale. Comme le montre la Figure 5, un dispositif à émission latérale 52 est monté sur la paroi latérale d'un bloc

6

de cuivre 54 faisant fonction de puits de chaleur pour le dispositif. Un élément de couplage de signaux 56 traverse le substrat en céramique 58 sur lequel est disposé le dispositif 52 de manière à assurer un couplage optique et, éventuellement, électrique avec ce dernier. Des broches métalliques pleines 60 de type classique peuvent traverser le substrat 58 afin d'établir les connexions électriques nécessaires. Certaines de ces broches métalliques peuvent pénétrer à l'intérieur du bloc de cuivre 54 pour réaliser un chemin thermique au travers du substrat en céramique de façon à permettre l'évacuation de la chaleur provenant d'un module dans lequel se trouve le dispositif 52.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

7

REVENDICATIONS

1.- Dispositif de couplage pour transducteur optique monté sur un substrat du genre dans lequel la partie active dudit transducteur fait face audit substrat et ledit substrat comporte une ouverture disposée au droit de la partie active dudit transducteur, caractérisé en ce qu'il comporte:

une broche creuse traversant ladite ouverture, et

des moyens de transmission de lumière s'étendant longitudinalement à l'intérieur de ladite broche, une extrémité desdits moyens de transmission de lumière étant disposée au voisinage immédiat de la partie active dudit transducteur.

2.- Dispositif selon la revendication 1, caractérisé en ce que:

ladite broche est constituée d'un matériau conducteur, et

des moyens sont prévus pour réaliser une connexion électrique entre ladite broche et ledit transducteur.

3.- Dispositif selon la revendication 1 ou 2, caractérisé en ce que ladite broche est disposée perpendiculairement audit substrat.

4.- Dispositif selon l'une quelconque des revendications précédentes, caractérisé en ce que lesdits moyens de transmission de lumière sont constitués par une fibre optique.

8

5.- Dispositif selon la revendication 4, caractérisé en ce que:

ladite broche comporte une partie protubérante du côté du substrat opposé à celui où se trouve ledit transducteur

l'autre extrémité de ladite fibre optique est disposée au niveau de l'extrémité de ladite partie protubérante de ladite broche, et

il comporte un raccord creux comprenant un évidement central venant s'emboîter sur ladite partie protubérante et comportant des moyens pour guider l'extrémité d'une fibre optique extérieure de façon à faciliter son alignement avec ladite fibre optique contenue dans ladite broche.

6.- Dispositif selon la revendication 5, caractérisé en ce que l'évidement central dudit raccord comporte:

une première partie cylindrique dont le diamètre est sensiblement égal au diamètre extérieur de ladite broche, de façon à venir s'emboîter sur cette dernière, et

une seconde partie de diamètre croissant dont le plus petit diamètre correspond sensiblement à celui de la fibre optique contenue dans ladite broche et allant en s'évasant du côté opposé à ladite partie cylindrique.

7.- Dispositif selon la revendication 6, en ce qu'elle dépend des revendications 2 à 5, caractérisé en ce que ledit raccord est en verre et est recouvert d'un revêtement conducteur s'étendant jusqu'à
l'intérieur de ladite première partie cyclindrique,
de façon à pouvoir réaliser un contact électrique
avec ladite broche.

8.- Dispositif selon l'une quelconque des revendications
précédentes, caractérisé en ce que ladite broche
est en cuivre.

# FIG. 1

# FIG. 2

0017701

2/2

FIG. 3

FIG. 5

FIG. 4

**Office européen des brevets**

# RAPPORT DE RECHERCHE EUROPEENNE

EP 80 10 0326.0

| Catégorie | Citation du document avec indication, en cas de besoin, des parties pertinentes | Revendication concernée | CLASSEMENT DE LA DEMANDE (Int. Cl.3) |
|---|---|---|---|
| | **DOCUMENTS CONSIDERES COMME PERTINENTS** | | |
| | US - A - 3 585 454 (J.S. ROBERTS) <br> * revendication; colonne 1, ligne 69 à colonne 2, ligne 5; colonne 2, lignes 20 à 49; colonne 3, lignes 8 et 9; fig. 2 * <br> -- | 1-3 | H 01 L 31/02 <br> G 02 B 7/26 |
| | US - A - 3 423 594 (A.G. GALOPIN) <br> * fig. 2, 6, 12 * <br> -- | 1 | |
| | Patents Abstracts of Japan, Vol. 1, No. 90, 22 août 1977 <br> page 2334E77 <br> & JP - A - 52 - 26191 <br> -- | 1 | **DOMAINES TECHNIQUES RECHERCHES (Int. Cl.3)** |
| | Patents Abstracts of Japan, Vol. 2, No. 141, 22 novembre 1978 <br> page 8857E78 <br> & JP - A - 53 - 108792 <br> -- | 1,2 | G 02 B 7/26 <br> H 01 L 31/02 <br> H 01 L 33/00 |
| A | Patents Abstracts of Japan, Vol. 3, No. 1, 11 janvier 1979 <br> page 26E82 <br> & JP - A - 53 - 126946 <br> -- | 5,6 | |
| A | FR - A1 - 2 387 519 (THOMSON-CSF) <br> * fig. 5 * <br> -- | | **CATEGORIE DES DOCUMENTS CITES** <br> X: particulièrement pertinent <br> A: arrière-plan technologique <br> O: divulgation non-écrite <br> P: document intercalaire <br> T: théorie ou principe à la base de l'invention <br> E: demande faisant interférence <br> D: document cité dans la demande <br> L: document cité pour d'autres raisons |
| A,P | DE - A1 - 2 846 773 (TE KA DE FELTEN & GUILLEAUME FERNMELDEANLAGEN) <br> * fig. 1A et 1B * <br> ---- | 5,6 | |
| | | | &: membre de la même famille, document correspondant |

☒ Le présent rapport de recherche a été établi pour toutes les revendications

| Lieu de la recherche | Date d'achèvement de la recherche | Examinateur |
|---|---|---|
| Berlin | 21-07-1980 | ROTHER |

OEB Form 1503.1  06.78